# EUROPEAN PATENT APPLICATION

(11) **EP 4 553 902 A1**
(43) Date of publication of application: **14.05.2025**
(21) Application number: 24172309.7
(22) Date of filing: 25.04.2024
(51) Int. Cl.: H01L 27/02, H01L 29/66, H01L 29/74

(54) **SILICON CONTROL RECTIFIER INTEGRATED WITH A TRANSISTOR**

(30) Priority: 09.11.2023 US 202318388441
(71) Applicant: GlobalFoundries U.S. Inc., Malta, NY 12020 (US)
(72) Inventor: NATH, Anindya, Essex Junction, VT, 05452 (US); RAGHUNATHAN, Uppili S., Essex Junction, VT, 05452 (US); KRISHNASAMY, Rajendran, Essex Junction, VT, 05452 (US); KARALKAR, Sagar Premnath, 738406 Singapore (SG); DERRICKSON, Alexander M., Malta, NY, 12020 (US); JAIN, Vibhor, Essex Junction, VT, 05452 (US)
(74) Representative: Lambacher, Michael

(57) **Abstract**

The present disclosure relates to semiconductor structures and, more particularly, to a silicon control rectifier (SCR) and methods of manufacture. The structure includes: a doped region in a semiconductor substrate; at least two regions of semiconductor material comprising opposite doping types over the doped region; and polysilicon regions over respective ones of the least two regions of semiconductor material.

## Description

### BACKGROUND

The present disclosure relates to semiconductor structures and, more particularly, to a silicon control rectifier (SCR) integrated with a transistor and methods of manufacture.

SCRs are used for electrostatic discharge (ESD) protection of integrated circuits (ICs) from the sudden flow of electricity caused by, for example, contact, electrical shorts, or dielectric breakdown. Because of high current handling ability per unit area of an SCR, ESD devices utilizing SCR can protect ICs from failure. These devices are most often used in high performance analog and radiofrequency (RF) designs for chips that have large signal swings, low leakage, and low capacitance. Due to the capacitance loading and poor harmonics of SCRs, RF performance may be impacted.

### SUMMARY

In an aspect of the disclosure, a structure comprises: a doped region in a semiconductor substrate; at least two regions of semiconductor material comprising opposite doping types over the doped region; and polysilicon regions over respective ones of the least two regions of semiconductor material.
Additional features of the structure are set forth in dependent claims 2 to 10.

In an aspect of the disclosure, a structure comprises: a first doped region of a first dopant type in a semiconductor substrate; a first semiconductor layer over the first doped region and have a first dopant type; a second semiconductor layer over the first doped region and have a second dopant type, opposite to the first dopant type; and polysilicon regions contacting the first semiconductor layer and the second semiconductor layer.
Additional features of the structure are set forth in dependent claims 12 to 14.

In an aspect of the disclosure, a method comprises: forming a doped region in a semiconductor substrate; forming at least two regions of semiconductor material comprising opposite doping types over the doped region; and forming polysilicon regions over respective ones of the least two regions of semiconductor material.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a top view of a silicon controlled rectifier (SCR) in a PNPN configuration and respective fabrication processes in accordance with aspects of the present disclosure.
FIG. 1B shows a cross-sectional view of the SCR device of FIG. 1A along line X1-X1, in accordance with aspects of the present disclosure.
FIG. 2A shows a top view of an SCR in a bipolar junction transistor (BJT) configuration in accordance with aspects of the present disclosure.
FIG. 2B shows a cross-sectional view of the SCR device of FIG. 2A along line X2-X2, in accordance with aspects of the present disclosure.
FIG. 2C shows a cross-sectional view of the SCR device of FIG. 2A along line X3-X3, in accordance with aspects of the present disclosure.
FIG. 3 shows a cross-sectional view of another SCR device in a BJT configuration in accordance with further aspects of the present disclosure.
FIG. 4A-4E show cross-sectional views of steps in the fabrication process of the SCR of FIGS. 1A and 1B in accordance with further aspects of the present disclosure.

### DETAILED DESCRIPTION

The present disclosure relates to semiconductor structures and, more particularly, to a silicon control rectifier (SCR) and methods of manufacture. In embodiments, the SCR includes a doped collector region, semiconductor regions of opposite dopant types formed on top of the doped collector region and separated by dielectric material, and an anode and cathode formed on doped polysilicon regions connecting to the semiconductor regions of opposite dopant types. Advantageously, the structures described herein exhibit lowered capacitance with less RF degradation, improved space savings, faster switching times and higher current drive due to more efficient bipolars and vertical integration.

In more specific embodiments, an SCR comprises an n-type region bounded by shallow trench isolation regions. Doped SiGe regions of opposite dopant types may be formed on top of the n-type region and separated by dielectric material. An anode and cathode are formed on n+ polysilicon and p+ polysilicon, contacting the SiGe regions of opposite dopant types. The SiGe regions of opposite dopant types may be, for example, p-SiGe and n-SiGe layers. In embodiments, ohmic contacts to p-SiGe and n-SiGe through the polysilicon regions may be parallel orthogonal to the anode/cathode.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

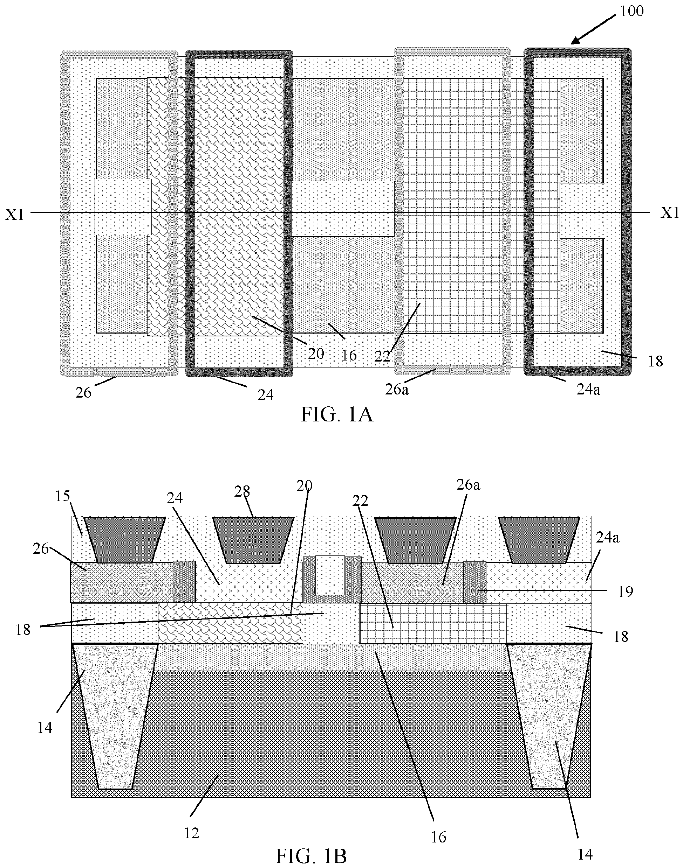

FIG. 1A shows a top view of an SCR in a PNPN configuration and respective fabrication processes, and FIG. 1B shows a cross-sectional view of the SCR device of FIG. 1A along line X1-X1. Referring to FIGS. 1A and 1B, the structure 100 includes a doped region 16 in a semiconductor substrate 12, p-type semiconductor material 20 and n-type doped semiconductor material 22 contacting the doped region 16, and polysilicon regions 24, 26 contacting the p-type doped semiconductor material 20. Similarly, polysilicon regions 24a, 26a contact the n-type doped semiconductor material 22.

In exemplary embodiments, the p-type doped semiconductor material 20 and n-type doped semiconductor material 22 may be single crystalline p-SiGe material and n-SiGe material, respectively. Also, the doped region 16 may be a sub-collector region comprising n-doped semiconductor material. And the polysilicon regions 24, 24a, 26, 26a may be doped polysilicon between and contacting contacts 28 (i.e., cathodes and anodes) and the respective SiGe regions 20, 22. The polysilicon regions 24, 24a, 26, 26a may also partly overlap with the insulator material 18. In embodiments, the polysilicon regions 24, 24a may comprise p+ type polysilicon and the polysilicon regions 26, 26a may comprise n+ type polysilicon. The p-type dopants may be, e.g., Boron (B), and the n-type dopants may be, e.g., Arsenic (As), Phosphorus (P) and Antimony (Sb), among other suitable examples. In this way, SCR may be an PNPN device.

In further embodiments, the semiconductor substrate 12 may be composed of any suitable semiconductor material including, but not limited to, Si, SiGe, SiGeC, SiC, GaAs, InAs, InP, and other III/V or II/VI compound semiconductors. The semiconductor substrate 12 may also comprise any suitable single crystallographic orientation (e.g., a (100), (110), (111), or (001) crystallographic orientation). In further embodiments, the semiconductor substrate 12 may be a bulk substrate comprising the semiconductor materials described herein or, alternatively, may comprise semiconductor on insulator technology as is known in the art. In the semiconductor on insulator technology, the semiconductor substrate 12 would be a top semiconductor layer over an insulator material and a handle substrate as is known in the art.

Shallow trench isolation regions 14 are formed within the semiconductor substrate 12, which may be adjacent to and isolate the sub-collector 16. In embodiments, the SiGe regions 20, 22 are aligned to the edges of the shallow trench isolation regions 14. That is, in preferred embodiments, the SiGe regions 20, 22 do not overlap with the shallow trench isolation regions 14 such that poly-SiGe layers will not form in the structure 100. In addition, it should be recognized by those of skill in the art, as with each of the different embodiments, the position of the p-SiGe region 20 and n-SiGe region 22 may be swapped.

In addition, the insulator material 18 may isolate the p-type doped semiconductor material 20 and n-type doped semiconductor material 22. In further embodiments, the insulator material 18 may be buried oxide material. In addition, the polysilicon regions 24, 26 may be isolated from one another by sidewall spacers 19. The sidewalls spacers 19 may be, for example, nitride material formed by conventional deposition methods (e.g., chemical vapor deposition (CVD), followed by anisotropic etching processes. Contacts 28 (i.e., cathodes and anodes) extend to the polysilicon regions 24, 26. In embodiments, the contacts 28 are parallel to one another and may be formed of any known conductive material, e.g., Tungsten, Al, Cu lined with TiN or TaN as examples. The contacts 20 may be formed in interlevel dielectric material 15 using conventional lithography, etching and deposition methods as is known in the art.

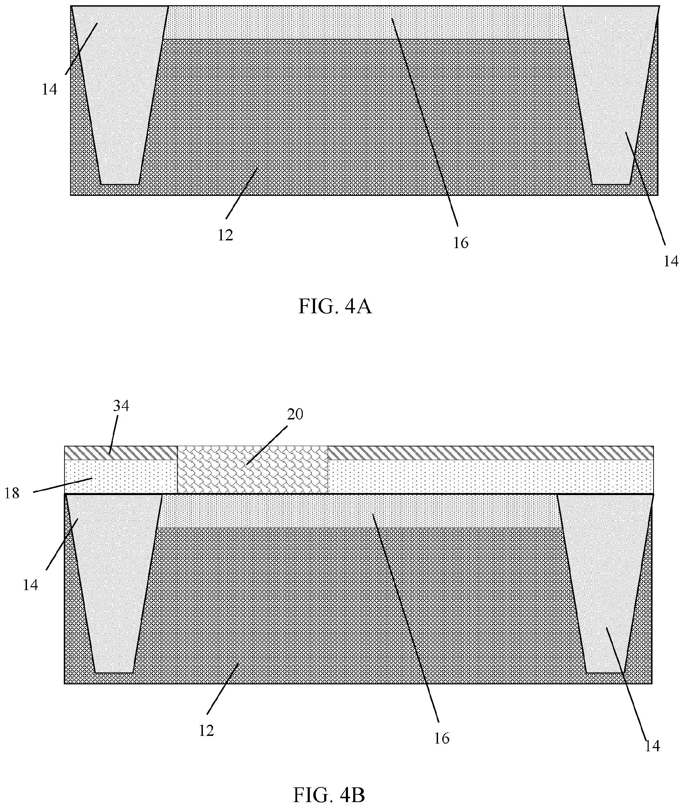

The sub-collector 16 may be formed by conventional implantation processes as described in more detail as further described with respect to FIG. 4A. In embodiments, the shallow trench isolation regions 14 may be formed by conventional lithography, etching, and deposition methods known to those of skill in the art as further described with respect to FIG. 4A. Moreover, the p-type doped semiconductor material 20 and n-type doped semiconductor material 22 may be formed by epitaxial growth processes with a respective in-situ doping process. Similarly, the polysilicon regions 24, 24a, 26, 26a may be formed by epitaxial growth processes with a respective in-situ doping process, over the insulator material 18. The p-type dopants may be, e.g., Boron (B), and the n-type dopants may be, e.g., Arsenic (As), Phosphorus (P) and Antimony (Sb), among other suitable examples.

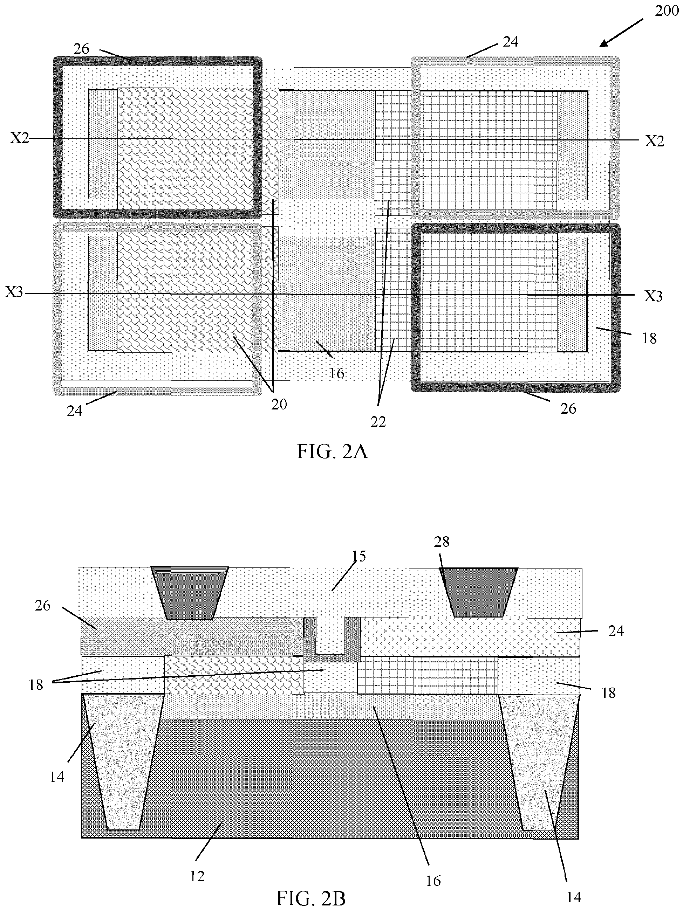

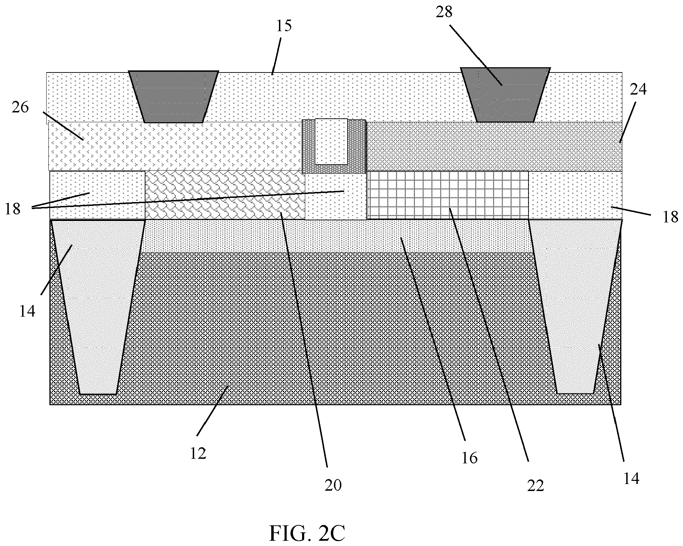

FIG. 2A shows a top view of an SCR in a bipolar junction transistor (BJT) configuration in accordance with additional aspects of the present disclosure. FIG. 2B shows a cross-sectional view of the SCR device of FIG. 2A along line X2-X2 and FIG. 2C shows a cross-sectional view of the SCR device of FIG. 2A along line X3-X3. In the structure 200 of FIGS. 2A-2C, the polysilicon regions 24, 26 are in a z-axis orientation relative to the device. Moreover, the ohmic contacts to the p-SiGe material 20 and n-SiGe material 22 through the poly p+ and n+ regions 24, 26 are orthogonal to the anode and cathode. For example, FIG. 2B shows the n-type doped polysilicon region 24 provided on and contacting the p-SiGe material 20 and the p-type doped polysilicon region 26 provided on and contacting the n-SiGe material 22. FIG. 2C, on the other hand, shows the p-type doped polysilicon region 26 provided on and contacting the p-SiGe material 20 and the n-type doped polysilicon region 24 provided on and contacting the n-SiGe material 22. The remaining features may also be similar to the structure 100 shown in FIGS. 1A and 1B such that no further explanation is required herein.

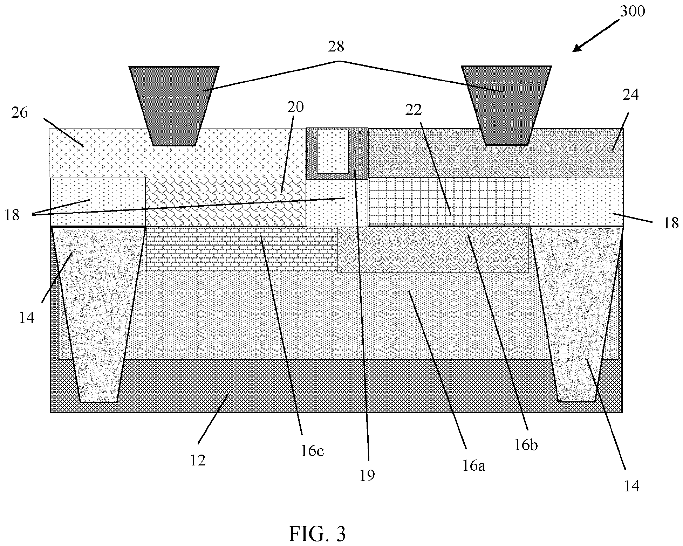

FIG. 3 shows a cross-sectional view of a SCR device in a BJT configuration. For example, the structure 300 comprises a p-type doped region 16c in an N-well 16a and adjacent to the n-type doped region 16b (which may be part of the N-well 16a). The p-type doped region 16c and the n-type doped region 16b may form a p-n junction. The p-type doped polysilicon region 26 may be provided on and contacting the p-SiGe material 20; whereas the n-type doped polysilicon region 24 may be provided on and contacting the n-SiGe material 22. Both the p-type doped polysilicon region 26 and the n-type doped polysilicon region 24 may overlap with the insulator material 18. The remaining features of the structure 200 may also be similar to the structure 100 shown in FIGS. 1A and 1B such that no further explanation is required herein.

FIG. 4A-4E show cross-sectional views of steps in the fabrication process of the SCR of FIGS. 1A and 1B in accordance with further aspects of the present disclosure. It should be understood by those of skill in the art that similar processes can also be used to fabricate the SCR structures 200 and 300 by, for example, using different in-situ dopants during epitaxial growth processes as described herein. In embodiments, the sub-collector regions may be formed by ion implantation processes as is known in the art such that no further explanation is required for a complete understanding of the present disclosure.

Referring to FIG. 4A, an n-type sub-collector 16 may be formed in the semiconductor substrate 12. For example, a patterned implantation mask is used to select the exposed area for forming the n-type sub-collector 16. The implantation mask may include a layer of a light-sensitive material, such as an organic photoresist, applied by a spin coating process, pre-baked, exposed to light projected through a photomask, baked after exposure, and developed with a chemical developer. The implantation mask has a thickness and stopping power sufficient to block masked areas against receiving a dose of the implanted ions. The n-type dopants may be, e.g., Arsenic (As), Phosphorus (P) and Sb, among other suitable examples.

Still referring to FIG. 4A, the shallow trench isolation regions 14 is formed adjacent to the n-type sub-collector 16. The shallow trench isolation regions 14 can be formed by conventional lithography, etching and deposition methods known to those of skill in the art. For example, a resist formed over the semiconductor substrate 12 is exposed to energy (light) and developed utilizing a conventional resist developer to form a pattern (opening). An etching process with a selective chemistry, e.g., reactive ion etching (RIE), will be used to transfer the pattern from the patterned photoresist layer to the semiconductor substrate 12 to form one or more trenches in the semiconductor substrate 12. Following the resist removal by a conventional oxygen ashing process or other known stripants, insulator material (e.g., SiO₂) can be deposited by any conventional deposition processes, e.g., chemical vapor deposition (CVD) processes. Any residual material on the surface of the semiconductor substrate 12 can be removed by conventional chemical mechanical polishing (CMP) processes.

In FIG. 4B, the p-SiGe material 20 is formed over the n-type sub-collector 16. To form the p-SiGe material 20, the insulator material 18 is deposited over the semiconductor substrate 12. The insulator material 18 may be deposited by any conventional deposition method, e.g., CVD. A masking layer 34 is deposited on the insulator material 18. The masking layer 34 may be nitride, deposited by a conventional deposition method, e.g., CVD. An opening is formed through the insulator material 18 and masking layer 34 to expose the underlying n-type sub-collector 16. The opening may be formed by conventional lithography and etching processes as is known in the art. A SiGe material is epitaxially grown on the exposed underlying n-type sub-collector 16. In embodiments, the epitaxial growth process includes an in-situ doping process with a p-type dopant to form the p-SiGe material 20.

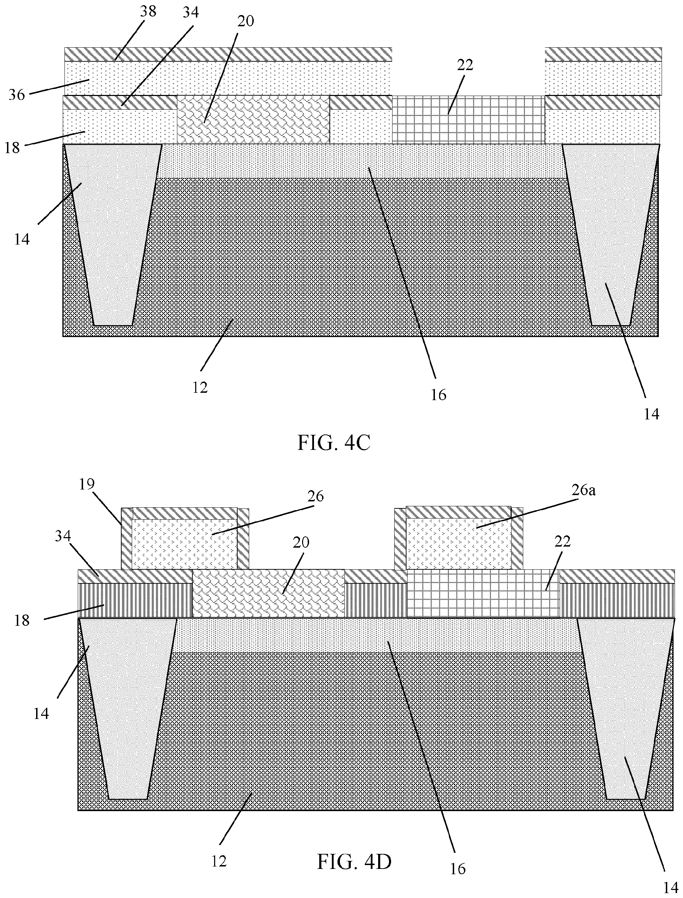

In FIG. 4C, the n-SiGe material 22 is formed over the n-type sub-collector 16. To form the n-SiGe material 22, insulator material 36 and masking layer 38 are formed over masking layer 34 using any conventional deposition method, e.g., CVD. As an example, the insulator material 36 may also be oxide and the masking layer 38 may also be nitride. An opening is formed through the insulator materials 18, 36 and masking layers 34, 38 to expose the underlying n-type sub-collector 16, again using conventional lithography and etching processes. A SiGe material is epitaxially grown on the exposed underlying n-type sub-collector 16. In embodiments, the epitaxial growth process includes an in-situ doping process with an n-type dopant to form the n-SiGe material 22.

In FIG. 4D, the insulator materials 18, 36 and masking layer 38 are removed by conventional stripping techniques such as a chemical mechanical polishing (CMP) or etching processes (e.g., reactive ion etching processes with selective chemistries) as is known in the art. The p+ type polysilicon regions 26, 26a may be formed over the p-SiGe material 20 and the n-SiGe material 22, overlapping with the insulator material 18. The epitaxial growth process may include an in-situ doping process with a p-type dopant, e.g., Boron. As is known in the art, the polysilicon material will form over the insulator material 18. Following a conventional patterning process, a sidewall spacer material 19, e.g., nitride, may be deposited and patterned over the p+ type polysilicon regions 26, 26a.

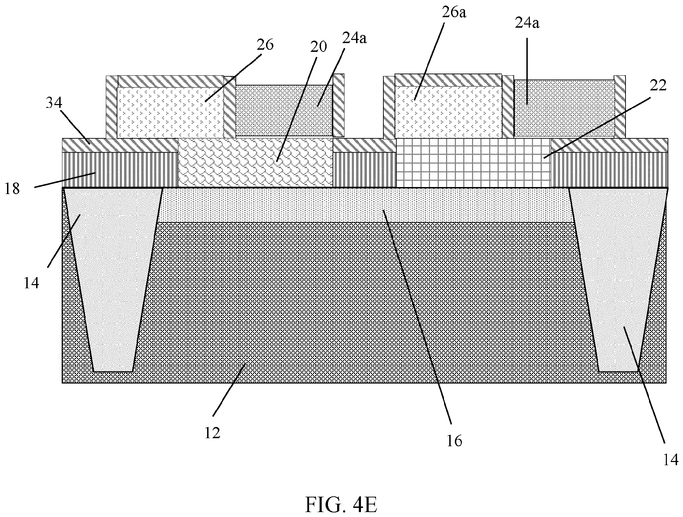

In FIG. 4E, n+ type polysilicon regions 24, 24a may be formed over the p-SiGe material 20 and the n-SiGe material 22, overlapping with the insulator material 18. The epitaxial growth process may include an in-situ doping process with a n-type dopant, e.g., Arsenic. Again, as is known in the art, the polysilicon material will form over the insulator material 18. Following a conventional patterning process, a sidewall spacer material 19, e.g., nitride, may be deposited and patterned over the n+ type polysilicon regions 24, 24a.

Referring back to FIG. 1B, for example, the contacts 28 may be formed through interlevel dielectric material 15 by conventional lithography, etching and deposition processes as is known in the art. Prior to the deposition of conductive material to form the contacts 28, a conventional silicide process may be used to provide silicide contacts to the regions. As should be understood by those of skill in the art, the silicide process begins with deposition of a thin transition metal layer, e.g., nickel, cobalt or titanium, over the exposed regions 24, 24a, 26, 26a. After deposition of the material, the structure is heated allowing the transition metal to react with exposed silicon (or other semiconductor material as described herein) forming a low-resistance transition metal silicide. Following the reaction, any remaining transition metal is removed by chemical etching, leaving silicide contacts in the active regions of the device.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a doped region in a semiconductor substrate;
at least two regions of semiconductor material comprising opposite doping types over the doped region; and
polysilicon regions over respective ones of the least two regions of semiconductor material.

2. The structure of claim 1, wherein the at least two regions of semiconductor material comprise n-SiGe material and p-SiGe material.

3. The structure of claim 2, wherein the doped region in the semiconductor substrate comprises an n-type doped region underlying and contacting both the n-SiGe material and p-SiGe material, and/or wherein the n-SiGe material and the p-SiGe material are positioned at edges of a shallow trench isolation structure and are separated by a dielectric material.

4. The structure of claim 2 or claim 3, wherein the polysilicon regions comprise a first p-type doped polysilicon region and a first n-doped polysilicon region over and contacting the n-SiGe material, and a second p-type doped polysilicon region and a second n-doped polysilicon region over and contacting the p-SiGe material.

5. The structure of claim 4, further comprising contacts which contacts the first and second n-doped polysilicon regions and the first and second p-doped polysilicon regions, and, optionally, wherein the contacts are parallel to one another.

6. The structure of one of claims 2 to 5, wherein the p-SiGe material and the n-SiGe material comprise single crystalline material.

7. The structure of one of claims 2 to 6, wherein the doped region in the semiconductor substrate comprises a p+ region in an n-well, and the n-SiGe material connects to the n-well and the p-SiGe material connections to the p+ region, and, optionally, wherein the polysilicon regions comprise a p-type doped polysilicon region connecting to the p-SiGe and an n-doped polysilicon region connecting to the n-SiGe.

8. The structure of one of claims 1 to 7, wherein the doped region comprises a p-n junction, and/or.

9. The structure of one of claims 1 to 8, wherein the least two regions of semiconductor material comprising a p-SiGe region, an n-SiGe region, and the polysilicon regions comprise:
a first n-type doped polysilicon material connecting to the p-SiGe region;
a second n-type doped polysilicon material connecting to the n-SiGe region;
a first p-type doped polysilicon material connecting to the p-SiGe region; and
a second n-type doped polysilicon material connecting to the n-SiGe region.

10. The structure of claim 9, wherein ohmic contacts are orthogonally positioned.

11. A structure comprising:
a first doped region of a first dopant type in a semiconductor substrate;
a first semiconductor layer over the first doped region and have a first dopant type;
a second semiconductor layer over the first doped region and have a second dopant type, opposite to the first dopant type; and
polysilicon regions contacting the first semiconductor layer and the second semiconductor layer.

12. The structure of claim 11, wherein the first semiconductor layer comprises p-SiGe layer and the second semiconductor layer comprises n-SiGi layer, and, optionally, wherein the polysilicon regions comprise: a first polysilicon and a second polysilicon of opposite dopant types contacting the p-SiGe layer; and a first polysilicon and a second polysilicon of opposite dopant types contacting the n-SiGe layer.

13. The structure of claim 11 or claim 12, wherein the first doped region comprises a p-n junction.

14. The structure of one of claims 11 to 13, further comprising:
contacts connecting to the polysilicon regions which are parallel to one another; and/or
contacts connecting to the polysilicon regions which are orthogonally positioned.

15. A method comprising:
forming a doped region in a semiconductor substrate;
forming at least two regions of semiconductor material comprising opposite doping types over the doped region; and
forming polysilicon regions over respective ones of the least two regions of semiconductor material.
